# DEMANDE DE BREVET EUROPEEN

(11) **EP 1 061 568 A1**
(43) Date de publication de la demande: **20.12.2000**
(21) Numéro de dépôt: 00410058.2
(22) Date de dépôt: 16.06.2000
(51) Int. Cl.: H01L 21/331, H01L 29/737, H01L 29/73

(54) **Procédé de fabrication autoaligné de transistors bipolaires**

(30) Priorité: 18.06.1999 FR 9907978
(71) Demandeur: STMicroelectronics SA, 94250 Gentilly (FR)
(72) Inventeur: Gris, Yvon, 38210 Tullins (FR)
(74) Mandataire: de Beaumont, Michel

(57) **Abrégé**

L'invention concerne la fabrication d'un transistor bipolaire comprenant les étapes consistant à déposer une couche de silicium polycristallin (5) de type P et une couche isolante (6) sur un substrat (3) de type N ; définir dans ces couches une ouverture de base-émetteur ; procéder à un dopage de type P et recuire pour former une région fortement dopée (8) s'étendant partiellement sous la périphérie de la couche de silicium polycristallin (5) ; former un espaceur (11-12) en un matériau isolant à l'intérieur de l'ouverture ; procéder à une gravure isotrope du silicium sur une épaisseur supérieure à celle de la région fortement dopée (8) pour former un évidement (14) ; former de façon conforme par épitaxie sélective une couche de silicium (18) de type P pour constituer la couche de base du transistor ; et déposer du silicium polycristallin (19) fortement dopé de type N pour constituer l'émetteur du transistor.

## Description

La présente invention concerne, de façon générale, la fabrication de dispositifs bipolaires. Elle s'applique à la fabrication de transistors bipolaires en technologie bipolaire pure ou en technologie mixte bipolaire-CMOS (BICMOS).

La fabrication des jonctions base-émetteur des transistors bipolaires pose différents problèmes. Il est en particulier souhaitable de disposer de procédés de fabrication autoalignés pour réduire les dimensions des dispositifs.

Il est également souhaitable de ne pas implanter la base ce qui crée inévitablement des profils de dopage gaussiens. L'idéal est de réaliser la base par un dépôt épitaxial dopé.

Il est également souhaitable de minimiser la résistance d'accès à la base (résistance de base) et d'améliorer la réponse en fréquence des transistors. Pour ce faire, on a notamment proposé d'utiliser comme base une couche de silicium-germanium. Toutefois, l'utilisation du germanium, bien qu'améliorant considérablement la résistance d'accès d'un transistor bipolaire et le temps de transit dans la base, pose des problèmes de mise en oeuvre. Il est difficile d'apporter ce germanium par une implantation dans une couche de silicium, et une telle couche ne supporte pas d'être soumise à de hautes températures (la température doit rester de façon stable inférieure à 900°C ; on peut néanmoins tolérer un recuit thermique rapide pas plus contraignant que 1030°C pendant 20 s).

Un objet de la présente invention est donc de proposer un nouveau procédé de fabrication de transistors bipolaires permettant de réaliser des jonctions base-émetteur de façon autoalignée.

Un autre objet de la présente invention est de proposer un tel procédé permettant de minimiser la résistance de base des transistors.

Un autre objet de la présente invention est de proposer un tel procédé compatible avec l'utilisation d'une région de base en silicium-germanium.

Pour atteindre ces objets, la présente invention prévoit un procédé de fabrication d'un transistor bipolaire comprenant les étapes consistant à définir une zone active dans la surface d'une couche de silicium d'un premier type de conductivité ; déposer une couche de silicium polycristallin dopée du deuxième type de conductivité et une couche isolante ; définir dans lesdites couches une ouverture de base-émetteur ; procéder à un dopage du deuxième type de conductivité et recuire pour former une région fortement dopée s'étendant partiellement sous la périphérie de la couche de silicium polycristallin ; former un espaceur en un matériau isolant à l'intérieur de l'ouverture ; procéder à une gravure isotrope du silicium sur une épaisseur supérieure à celle de ladite région fortement dopée pour former un évidement ; former de façon conforme par épitaxie sélective une couche de silicium du deuxième type de conductivité pour constituer la couche de base du transistor ; et déposer du silicium polycristallin fortement dopé du premier type de conductivité pour constituer l'émetteur du transistor.

Selon un mode de réalisation de la présente invention, la couche déposée par épitaxie contient du germanium sur au moins une partie de son épaisseur.

Selon un mode de réalisation de la présente invention, l'espaceur est un espaceur en nitrure de silicium et oxyde de silicium.

Selon un mode de réalisation de la présente invention, l'étape de gravure isotrope est suivie d'une étape d'implantation profonde d'un dopant du premier type de conductivité pour former une zone de collecteur enterré.

Selon un mode de réalisation de la présente invention, le procédé comprend en outre, après l'étape de dépôt conforme par épitaxie, l'étape de formation d'un deuxième espaceur à l'intérieur d'un premier espaceur.

Selon un mode de réalisation de la présente invention, le niveau de dopage de ladite région fortement dopé est supérieur à 10¹⁹ at./cm³.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

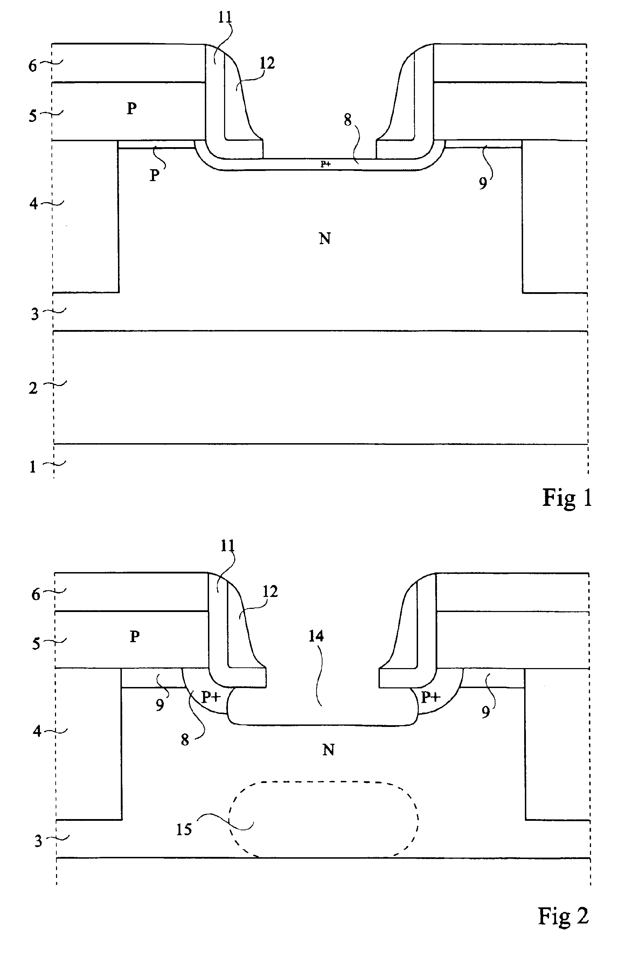

les figures 1 à 3 sont des vues en coupe partielles et schématiques d'un transistor bipolaire à différentes étapes d'un exemple de mise en oeuvre d'un procédé de fabrication selon un mode de réalisation de la présente invention.

Par souci de clarté, les mêmes éléments ont été désigués par les mêmes références aux différentes figures. De plus, comme cela est habituel dans la représentation des circuits intégrés, les diverses figures ne sont pas tracées à l'échelle.

La figure 1 représente l'état d'un substrat de silicium 1 d'un premier type de conductivité, par exemple de type P, après des étapes initiales d'un procédé selon un mode de réalisation de la présente invention. Le substrat comprend du côté de sa face supérieure des régions 2 et 3 du deuxième type de conductivité, par exemple N, respectivement fortement et faiblement dopées. La région 2 résulte par exemple d'une implantation/diffusion dans le substrat 1, et la région 3 d'une croissance épitaxiale. Des régions isolantes, par exemple des tranchées remplies d'un matériau d'isolement de champ 4, tel que de l'oxyde de silicium (SiO₂), délimitent dans la région 3 des zones actives. L'ensemble est recouvert d'une couche 5 de silicium, de préférence polycristallin, fortement dopé de type P. Le dopage est de préférence effectué par implantation de bore suivie d'un recuit léger pour obtenir une diffusion peu profonde (9) dans le silicium 3. La couche 5 est recouverte d'une couche isolante 6. On ouvre ensuite les couches 6 et 5 de façon à former une ouverture qui découvre une zone sensiblement centrale de la région active 3 dans laquelle doit être formé un transistor bipolaire.

La gravure des couches 6 et 5 pour former l'ouverture susmentionnée entraîne une surgravure superficielle de la couche 3 de silicium. Cette surgravure présente l'avantage d'assurer un nettoyage superficiel de la couche 3 et d'éliminer d'éventuelles pollutions. On procède ensuite à une implantation à forte dose d'un dopant de type P, par exemple à une dose de 5.10¹⁴ à 2.10¹⁵ atomes/cm² sous une énergie de 5 à 10 keV. On obtient ainsi une région 8 de type P⁺ qui s'étend sous l'ouverture et sous la périphérie interne de la couche 5 de silicium dopé de type P.

Ensuite, on réalise un espaceur en un matériau isolant à l'intérieur de l'ouverture formée dans les couches 6 et 5. Dans l'exemple de réalisation représenté, l'espaceur est constitué à partir de couches successives de nitrure de silicium 11 et d'oxyde de silicium 12. Cet espaceur est formé selon des techniques classiques par dépôt des couches 11 et 12 et gravure anisotrope.

La figure 2 illustre la structure selon la présente invention après une étape de gravure sélective et isotrope du silicium. Comme le représente la figure 2, cette gravure est poursuivie jusqu'à éliminer complètement la partie de la région 8 dopée de type P⁺ située à l'intérieur de l'ouverture définie par l'espaceur 11, 12. Pour être certain d'éliminer complètement la région 8, on poursuit la gravure jusqu'à graver une partie de la couche épitaxiée 3. On obtient ainsi un évidement 14 qui, du fait que la gravure est isotrope, s'étend partiellement sous la périphérie interne de l'espaceur 11, 12. Pour la réalisation de la gravure isotrope, on pourra avoir recours à une gravure par un plasma de SF₆ et NF₃ dans des conditions propres à obtenir simultanément une gravure isotrope et une bonne sélectivité de la gravure du silicium par rapport à la gravure de SiO₂ et Si₃N₄. On notera qu'il demeure une couronne périphérique de la région 8 très fortement dopée de type P⁺ en contact avec la région de silicium polycristallin 5 fortement dopée de type P.

Après formation de l'évidement 14, on effectue de préférence une implantation à haute énergie (par exemple 200 keV) pour former au fond de la région 3, en contact avec la région 2, une région 15 fortement dopée de type N destinée à constituer le fond du collecteur du transistor bipolaire. Le fait de réaliser cette implantation après formation de l'évidement permet de réduire l'énergie d'implantation et d'obtenir un collecteur enterré bien localisé sous la base. Avant l'implantation de la région 15, on fait de préférence croître un oxyde thermique qui est ensuite éliminé par gravure humide. La formation d'un contact ohmique avec la région 2 se fait de façon classique et n'est pas décrite ni représentée ici.

On procède alors à un recuit thermique rapide qui fait notamment diffuser le dopant P contenu dans les parties restantes de la région 8 et assure un bon contact électrique entre le silicium polycristallin fortement dopé de type P de la couche 5 et des régions P 8 et 9.

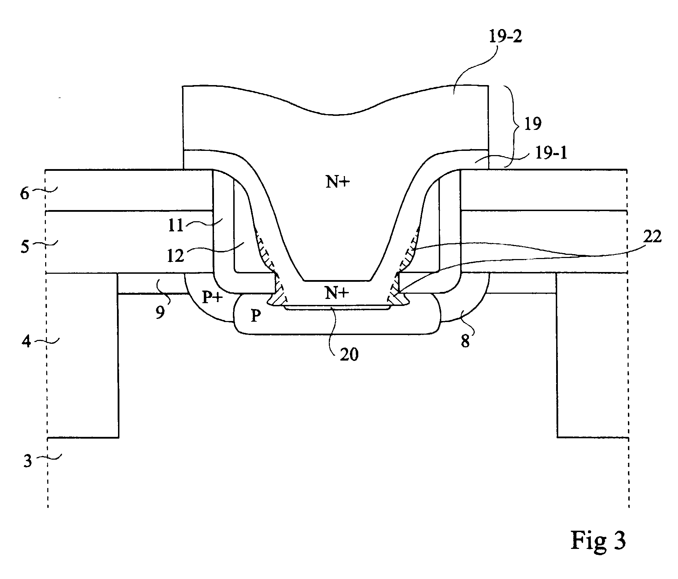

Aux étapes suivantes dont le résultat est illustré en figure 3, on fait croître une couche 18 de silicium sur une épaisseur inférieure à la profondeur de l'évidement 14. La couche 18 est destinée à constituer la base du transistor bipolaire et est formée par un procédé d'épitaxie sélective de façon à se développer seulement à partir des surfaces de silicium. Toutes les surfaces de silicium apparentes étant monocristallines, la couche 18 sera monocristalline. La couche 18 est dopée à l'aide d'un dopant de type P, par exemple du bore à une concentration de l'ordre de 5x10¹⁸ atomes/cm³.

Pour former l'émetteur du transistor bipolaire, on dépose une couche 19 de silicium polycristallin fortement dopée de type N, par exemple de l'arsenic. De préférence le dépôt de la couche 19 est effectué en deux temps. Dans un premier temps, on procède à un dépôt à un niveau de dopage particulièrement élevé d'une première couche de silicium polycristallin 19-1. On procède ensuite à un dépôt fortement mais normalement dopé d'une deuxième partie plus épaisse de silicium polycristallin 19-2, par exemple à un niveau de dopage de l'ordre de 10²⁰ à 10²¹ atomes/cm³. L'avantage d'avoir une sous-couche particulièrement dopée est que l'on facilite ainsi une diffusion à basse température du dopant de type N dans la partie superficielle 20 de la couche de base 18.

De préférence, avant d'effectuer le dépôt de la couche de silicium polycristallin 19, on réalise un espaceur 22 en un matériau isolant. L'espaceur 22 est destiné à augmenter la distance entre la périphérie externe de la région d'émetteur 20 diffusée dans la base 18 et la périphérie interne de la partie de reprise de contact de base 8 existant à la périphérie de la région de base 18. On améliore ainsi les caractéristiques du transistor et notamment son gain. L'espaceur 22 est formé de toute façon classique et est par exemple en oxyde de silicium.

Le procédé s'achève de façon classique par la gravure des parties inutiles de la couche 19 et des couches 6 et 5, une encapsulation dans de l'oxyde de silicium, un recuit thermique rapide d'activation de la région d'émetteur 20, la réalisation de prises de contact de base et d'émetteur. On formera également un contact avec la couche 2 de façon à former une prise de contact de collecteur, en dehors du plan représenté.

La présente invention s'applique tout particulièrement à la formation de transistors dont la base est en silicium-germanium. En effet, lors de l'étape de dépôt épitaxial de la couche de base 18 décrite précédemment en relation avec la figure 3, il est possible de prévoir qu'une partie au moins de l'épaisseur de la couche 18 soit en alliage silicium-germanium, selon un profil de concentration choisi. Les profils de concentration du germanium et du dopant, par exemple du bore, inséré dans la couche 18 sont de préférence tels que leurs pics de concentration maximale à l'intérieur de la couche 18 soient distincts et que celui du germanium soit plus proche de la jonction collecteur-base 3-18 que celui du bore.

Le procédé selon l'invention est bien adapté à la formation d'une couche de silicium-germanium car il est possible de réaliser une partie des recuits à température élevée avant la formation de la couche épitaxiée conforme 18.

Dans un mode de réalisation de la présente invention les caractéristiques des diverses couches et gravures seront les suivantes :
- région 2 :
   épaisseur : de 1 à 3 µm, de préférence 2 µm ;
   dopage : 2x10¹⁹ at./cm³ d'arsenic ;
- région 3 (formée par épitaxie) :
   épaisseur : de 0,5 à 1 µm ;
   dopage : 1x10¹⁶ at./cm³ d'arsenic ;
- région 8 de type P⁺ :
   10¹⁹ à 10²⁰ at./cm³ de bore ; épaisseur d'environ 30 nm après implantation, 50 à 150 nm de préférence de l'ordre de 100 nm après recuit ;
- région de base 18 dopée de type P :
   épaisseur : de 30 à 100 nm
   dopage : 5.10¹⁸ à 5.10¹⁹ at./cm³ de bore ;
- espaceur 11-12 :
   couche 11 en nitrure de silicium, d'une épaisseur de 10 à 50 nm, de préférence de l'ordre de 30 nm ;
   couche 12 en oxyde de silicium, d'une épaisseur de 30 à 150 nm, de préférence de l'ordre de 80 nm.

Bien entendu, la présente invention est susceptible de diverses variantes et modifications qui apparaîtront à l'homme de l'art. En particulier, on a décrit et illustré précédemment les principes de l'invention appliqués à la formation d'un transistor bipolaire de type NPN. Toutefois, l'homme de l'art comprendra que l'on pourrait former selon les mêmes principes un transistor bipolaire de type PNP à condition de doper de façon complémentaire les différentes parties, couches ou portions en silicium. L'homne de l'art saura également adapter les matériaux décrits à une filière de fabrication spécifique et sélectionner les niveaux de dopage des diverses couches semiconductrices en fonction des performances recherchées.

## Revendications

1. Procédé de fabrication d'un transistor bipolaire comprenant les étapes suivantes :
définir une zone active dans la surface d'une couche de silicium (3) d'un premier type de conductivité ;
déposer une couche de silicium polycristallin (5) dopée du deuxième type de conductivité et une couche isolante (6) ;
définir dans lesdites couches une ouverture de base-émetteur ;
procéder à un dopage du deuxième type de conductivité et recuire pour former une région fortement dopée (8) s'étendant partiellement sous la périphérie de la couche de silicium polycristallin (5) ;
former un espaceur (11-12) en un matériau isolant à l'intérieur de ladite ouverture ;
caractérisé en ce qu'il comprend en outre les étapes consistant à :
procéder à une gravure isotrope du silicium sur une épaisseur supérieure à celle de ladite région fortement dopée (8) pour former un évidement (14) ;
former de façon conforme par épitaxie sélective une couche de silicium (18) du deuxième type de conductivité pour constituer la couche de base du transistor ; et
déposer du silicium polycristallin (19) fortement dopé du premier type de conductivité pour constituer l'émetteur du transistor.

2. Procédé selon la revendication 1, caractérisé en ce que la couche (18) déposée par épitaxie contient du germanium sur au moins une partie de son épaisseur.

3. Procédé selon la revendication 1, caractérisé en ce que l'espaceur est un espaceur en nitrure de silicium (11) et oxyde de silicium (12).

4. Procédé selon la revendication 1, caractérisé en ce que l'étape de gravure isotrope est suivie d'une étape d'implantation profonde d'un dopant du premier type de conductivité pour former une zone de collecteur enterré (15).

5. Procédé selon la revendication 1, caractérisé en ce qu'il comprend en outre, après l'étape de dépôt conforme par épitaxie, l'étape de formation d'un deuxième espaceur (20) à l'intérieur d'un premier espaceur.

6. Procédé selon la revendication 1, caractérisé en ce que le niveau de dopage de ladite région fortement dopé est supérieur à 10¹⁹ at./cm³.
